(19) Europäisches Patentamt / European Patent Office / Office européen des brevets

(11) **EP 3 761 463 A1**

(12) **EUROPEAN PATENT APPLICATION**
published in accordance with Art. 153(4) EPC

(43) Date of publication:
**06.01.2021 Bulletin 2021/01**

(21) Application number: **19757811.5**

(22) Date of filing: **16.01.2019**

(51) Int Cl.:
*H01S 5/022* (2021.01)   *B23K 26/00* (2014.01)
*G02B 26/06* (2006.01)   *H01S 3/00* (2006.01)
*H01S 3/10* (2006.01)

(86) International application number:
**PCT/JP2019/001030**

(87) International publication number:
**WO 2019/163335 (29.08.2019 Gazette 2019/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2018 JP 2018032343**

(71) Applicant: **Panasonic Intellectual Property Management Co., Ltd.
Osaka-shi, Osaka 540-6207 (JP)**

(72) Inventor: **ICHIHASHI, Kouki
Osaka-shi, Osaka 540-6207 (JP)**

(74) Representative: **Eisenführ Speiser
Patentanwälte Rechtsanwälte PartGmbB
Postfach 31 02 60
80102 München (DE)**

(54) **LIGHT RESONATOR AND LASER PROCESSING MACHINE**

(57)   An optical resonator (2) includes a light source (3) and an output coupler (4). The light source emits light. The output coupler resonates the light emitted from the light source to emit output light (L1). The output coupler includes a mirror (44), a polarization beam splitter (42), at least one quarter-wave plate (43), and an adjuster (40). The mirror is arranged to reflect the light from the light source. The polarization beam splitter is arranged on a light path between the light source and the mirror, emitting, out of incident light reflected on the mirror, a first polarized component to the light source and a second polarized component as the output light. The quarter-wave plate is arranged between the polarization beam splitter and the mirror, having an optical axis (a3) that provides phase difference by quarter wavelength in incident light. The adjuster adjusts a direction of the optical axis of the quarter-wave plate.

FIG. 2

## Description

TECHNICAL FIELD

The present disclosure relates to an optical resonator and a laser processing machine including the optical resonator.

BACKGROUND ART

Patent Document 1 discloses an optical resonator used in a laser oscillator and a wavelength conversion device. The optical resonator of Patent Document 1 is a ring resonator, which is configured by arranging a plurality of polarizers in a ring shape. Patent Document 1 has achieved to obtain a wide wavelength region for oscillation by replacing mirrors in the conventional resonator with polarizers.

CITATION LIST

PATENT DOCUMENT

Patent Document 1: JP 2002-344051 A

SUMMARY

The present disclosure provides an optical resonator and a laser processing machine which facilitate adjustment of an oscillation efficiency of light.

The optical resonator according to the present disclosure includes a light source and an output coupler. The light source emits light. The output coupler resonates the light emitted from the light source to emit output light. The output coupler includes a mirror, a polarization beam splitter, at least one quarter-wave plate, and an adjuster. The mirror is arranged to reflect the light from the light source. The polarization beam splitter is arranged on a light path between the light source and the mirror, and emits, out of light incident thereon after emitted from the mirror, a first polarized component to the light source and a second polarized component as output light. The quarter-wave plate is arranged between the polarization beam splitter and the mirror, and has an optical axis that provides a phase difference by a quarter wavelength in light incident thereon. The adjuster adjusts a direction of the optical axis of the quarter-wave plate.

The laser processing machine according to the present disclosure includes the optical resonator and a controller that controls light emission of the light source in the optical resonator.

According to the optical resonator and the laser processing machine of the present disclosure, the adjustment of the oscillation efficiency of light can be facilitated by adjusting the direction of the optical axis of the quarter-wave plate.

BRIEF DESCRIPTION OF THE DRAWINGS

FIG. 1 is a diagram showing a configuration of a laser processing machine according to a first embodiment of the present disclosure.
FIG. 2 is a diagram showing a configuration of an optical resonator according to the first embodiment.
FIG. 3 is a diagram for illustrating a beam of a laser emitter in the optical resonator.
FIG. 4 is a side view showing an arrangement example of a first optical element of a beam twister unit (BTU) in the optical resonator.
FIG. 5 is a perspective view showing a configuration example of a second optical element of the BTU in the optical resonator.
FIG. 6 is a diagram for illustrating a light combining method in a diffractive element of the optical resonator.
FIG. 7 is a graph showing a spectrum of resonance wavelengths in the optical resonator.
FIG. 8 is a diagram for illustrating a mechanism of an output coupler in the optical resonator.
FIG. 9 is a diagram showing a relationship between an optical axis of a quarter-wave plate of the output coupler and a polarization direction.
FIG. 10 is a diagram showing a configuration of an optical resonator according to a second embodiment.
FIG. 11 is a diagram showing a relationship between optical axes of two quarter-wave plates and the polarization direction.

DESCRIPTION OF EMBODIMENTS

Hereinafter, embodiments will be described in detail with reference to the drawings as appropriate. However, an unnecessarily detailed description may be omitted. For example, a detailed description of a well-known item or redundant descriptions of substantially the same configurations may be omitted. This is to prevent the following description from being unnecessarily redundant and to facilitate understanding by those skilled in the art.

It should be noted that the applicant provides the accompanying drawings and the following description for those skilled in the art to fully understand the present disclosure, and is not intended to limit the subject matter described in the claims by these.

(First embodiment)

In a first embodiment, a description is made for an optical resonator having a configuration that can change an oscillation efficiency without replacing an optical component, and a laser processing machine using the optical resonator.

1. Configuration

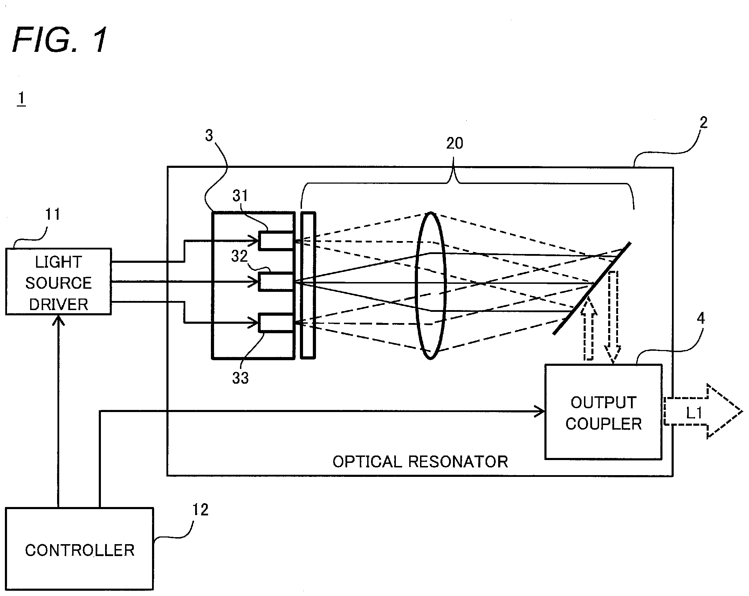

The configurations of the laser processing machine and the optical resonator according to the first embodiment are described with reference to FIG. 1. FIG. 1 is a diagram showing the configuration of a laser processing machine 1 according to the present embodiment.

As shown in FIG. 1, the laser processing machine 1 according to the present embodiment includes an optical resonator 2, a light source driver 11, and a controller 12. The laser processing machine 1 performs laser processing such as spot welding by using output light L1 generated in the optical resonator 2 as a laser output in a state suitable for the processing such as condensing the output light L1 by an optical system (not shown) including a lens, for example.

In the present embodiment, the optical resonator 2 is constituted of a wavelength addition type optical resonator that spatially combines beams of light emitted from a plurality of laser emitters 31 to 33 at resonance wavelengths different from each other. According to the wavelength addition type optical resonator 2, a beam diameter can be easily narrowed and a good beam quality can be obtained.

The light source driver 11 is a drive circuit that drives each of the laser emitters 31 to 33 as a light source in the optical resonator 2. For example, the light source driver 11 causes the laser emitters 31 to 33 to emit light under various oscillation conditions under the control of the controller 12. The various oscillation conditions include, for example, pulsed oscillation and continuous oscillation.

The controller 12 is a control device that controls the overall operation of the laser processing machine 1. The controller 12 includes, for example, a central processing unit (CPU) or micro processing unit (MPU) for realizing a predetermined function in cooperation with software. The controller 12 includes an internal memory such as a flash memory that stores various programs and data.

The controller 12 may include various interfaces that allow a user to input the oscillation conditions and the like. The controller 12 may include hardware circuits such as an application specific integrated circuit (ASIC) and a field-programmable gate array (FPGA) for realizing various functions. The controller 12 may be configured integrally with the light source driver 11, and the function of the light source driver 11 may be realized in the controller 12.

As shown in FIG. 1, the optical resonator 2 according to the present embodiment includes a light source 3 including the plurality of laser emitters 31 to 33, an output coupler 4 that emits the output light L1, and a coupling optical system 20 arranged between the light source 3 and the output coupler 4. The optical resonator 2 of the present embodiment resonates light in a light path for traveling back and forth between the light source 3 and the output coupler 4.

In the optical resonator 2 of the present embodiment, the output coupler 4 has a configuration that can change a ratio between light emitted as the output light L1 and light internally reflected and returned to the side of the light source 3 (i.e., reflectance). Thereby, the adjustment of the light oscillation efficiency in the optical resonator 2 is achieved. Hereinafter, details of the configuration of the optical resonator 2 are described.

1-1. Configuration of optical resonator

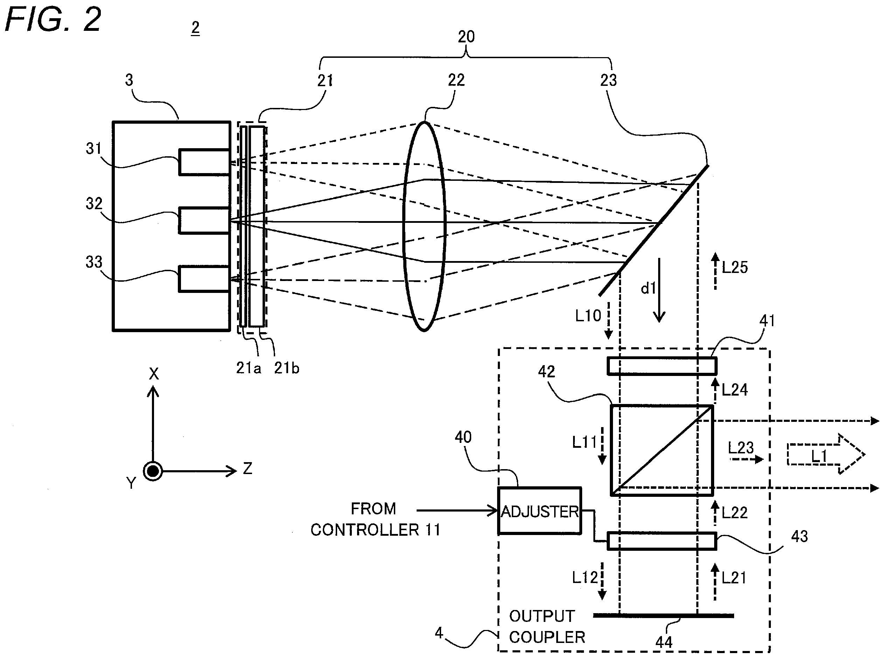

The configuration of the optical resonator 2 according to the present embodiment is described with reference to FIGS. 2 to 7. FIG. 2 is a diagram showing the configuration of the optical resonator 2 according to the present embodiment.

In the optical resonator 2 of the present embodiment, the plurality of laser emitters 31 to 33 are arranged in a line in the light source 3, as shown in FIG. 2. Hereinafter, a direction in which the laser emitters 31 to 33 are aligned is referred to as an "X direction", a direction of an optical axis of light emitted from the laser emitters 31 to 33 is referred to as a "Z direction", and a direction orthogonal to the X and Z directions is referred to as a "Y direction".

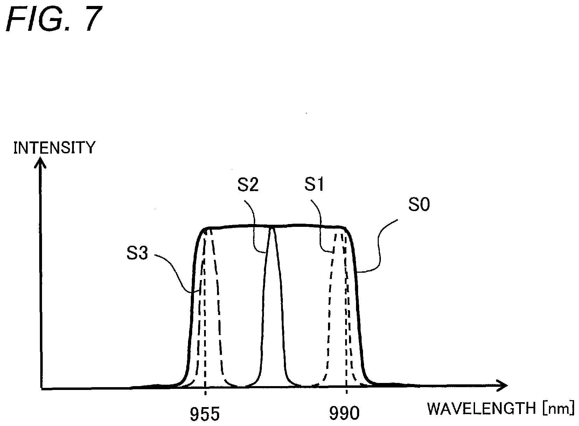

In the light source 3, each of the laser emitters 31 to 33 is, for example, a laser diode (LD) and is an example of a light emitter. The plurality of laser emitters 31 to 33 have a common spontaneous emission spectrum depending on, for example, material of an LD light emitting layer (see FIG. 7). In FIG. 2, three pieces of the laser emitters 31, 32, and 33 included in the light source 3 are illustrated. The number of pieces of laser emitters 31 to 33 in the light source 3 is, for example, several tens.

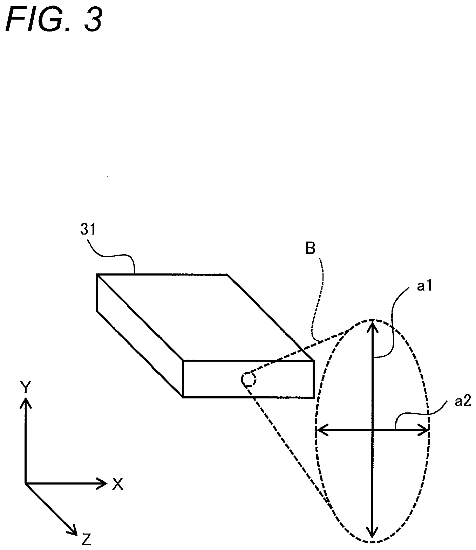

The beams of the laser emitters 31 to 33 in the light source 3 are described with reference to FIG. 3. FIG. 3 illustrates an emission state of a beam B of light from the laser emitter 31. The beam B of the laser emitter 31 has a fast axis a1 and a slow axis a2 which are orthogonal to each other.

In the light emitted from the laser emitter 31, the beam B spreads as the beam B proceeds in the +Z direction as illustrated in FIG. 3. The fast axis a1 defines a direction in which the beam B spreads more rapidly than the slow axis a2. In the present embodiment, in the vicinity of the laser emitter 31, the fast axis a1 is oriented in the Y direction and the slow axis a2 is oriented in the X direction.

Returning to FIG. 2, the coupling optical system 20 includes a BTU 21, a lens 22 and a diffractive element 23 which are sequentially arranged in the +Z direction from the vicinity of the light source 3.

The BTU 21 includes first and second optical elements 21a and 21b, and adjusts the beam of light from each of the laser emitters 31 to 33 of the light source 3. The first optical element 21a and the second optical element 21b are sequentially arranged in the +Z direction in the vicinity of the light source 3.

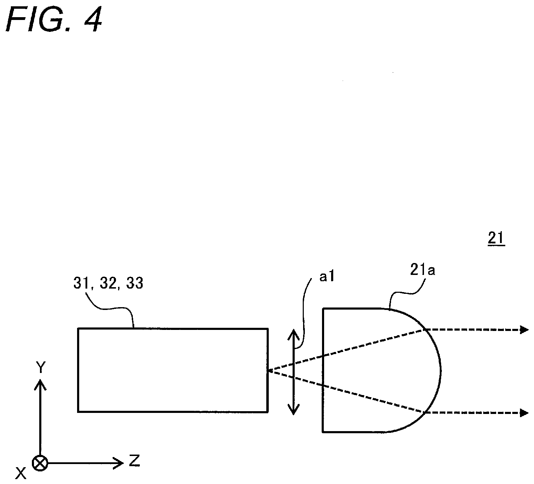

The first optical element 21a of the BTU 21 is, for example, a fast axis collimator (FAC) including a cylindrical lens. FIG. 4 shows an arrangement example of the first optical element 21a in view of the X direction. The first optical element 21a is arranged along the X direction so as to face each of the laser emitters 31 to 33 in the light source 3. As shown in FIG. 4, the first optical element 21a collimates the beam of light emitted from each of the laser emitters 31 to 33 in the Y direction, that is, in the direction of the fast axis a1 of the beam in the vicinity of the laser emitters 31 to 33.

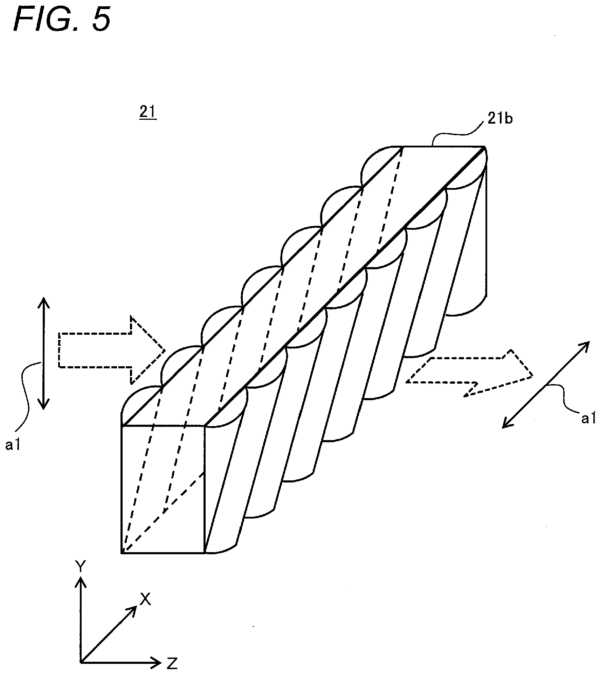

The second optical element 21b of the BTU 21 is, for example, a beam twister configured by combining a plurality of cylindrical lenses each of which faces each of the laser emitters. FIG. 5 shows a configuration example of the second optical element 21b. The second optical element 21b faces each of the laser emitters 31 to 33 with the first optical element 21a interposed therebetween. The second optical element 21b rotates the beam of light incident from the first optical element 21a by a rotation angle of 90° in an XY plane. As a result, the fast axis a1 of the beam of light emitted from the BTU 21 is directed in the X direction.

As shown in FIG. 2, the lens 22 makes the beams of the plurality of laser emitters 31 to 33 incident from the -Z side via the BTU 21 into substantially collimated beams of light in the X direction. The lens 22 includes one or more lens elements and has a positive refractive power in the X direction. The lens 22 is arranged, for example, so that a distance to the +Z-side end surface of the second optical element 21b of the BTU 21 matches a focal length of the lens 22. The diffractive element 23 is arranged in the vicinity of a focus of the lens 22 on the +Z side.

The diffractive element 23 is, for example, a dispersive element in which a transmission type diffraction grating is formed. In the present embodiment, the diffraction grating of the diffractive element 23 satisfies a diffraction condition for emitting beams of light from the plurality of laser emitters 31 to 33 in the same direction and combining the beams of light. The diffraction condition of the diffractive element 23 is expressed by the following equation (1).

$$\sin\alpha - \sin\beta = m\lambda/d \quad ...(1)$$

Here, $\alpha$ is an incident angle of light that is incident on the diffractive element 23, and $\beta$ is a diffraction angle of light that is emitted after diffraction. Further, $\lambda$ is a wavelength of the diffracted light and corresponds to a resonance wavelength; d is a pitch of the diffraction grating in the diffractive element 23; m indicates an order of diffraction, and is an integer, for example.

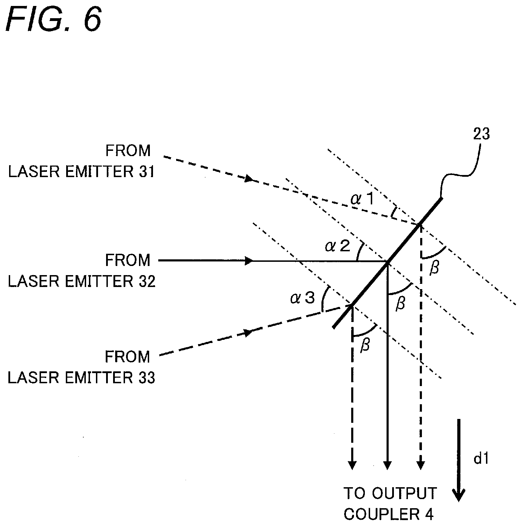

FIG. 6 is a diagram for illustrating a light combining method in the diffractive element 23. Hereinafter, as shown in FIG. 2, a direction of light emitted from the diffractive element 23 at the diffraction angle $\beta$ is referred to as "d1".

At the diffractive element 23, as shown in FIG. 6, the incident angles $\alpha = \alpha1$, $\alpha2$, and $\alpha3$ of the beams of light from the laser emitters 31, 32, and 33 are different from each other. In the optical resonator 2 of the present embodiment, different resonance wavelengths $\lambda$ are set to the laser emitters 31 to 33 based on the above equation (1) so as to make the diffraction angles $\beta$ of the laser emitters 31 to 33 the same. As a result, the beams of light from the plurality of laser emitters 31 to 33 are spatially combined when the beams pass through the diffractive element 23, and are emitted in the +d1 direction.

FIG. 7 is a graph showing a spectrum of the resonance wavelength $\lambda$ in the optical resonator 2. In the graph of FIG. 7, a horizontal axis represents a wavelength [nm] and a vertical axis represents a light intensity.

FIG. 7 shows individual resonance spectra S1 to S3 of the plurality of laser emitters 31 to 33 in the light source 3, and a common spontaneous emission spectrum S0. Each of the resonance spectra S1, S2, and S3 shows a distribution of the resonance wavelength $\lambda$ of each of the laser emitters 31, 32, and 33. The spontaneous emission spectrum S0 includes, for example, a wavelength band of 955 nm to 990 nm. The wavelength band of the laser emitter is not particularly limited to this, and for example, a laser emitter having the wavelength band of 400 nm may be used.

As shown in FIG. 7, in the optical resonator 2 of the present embodiment, various parameters of the optical resonator 2 are set such that all the resonance spectra S1 to S3 of the laser emitters 31 to 33 in the light source 3 are within the range of the spontaneous emission spectrum S0. The various parameters of the optical resonator 2 are, for example, a pitch of the laser emitters 31 to 33 in the light source 3, the focal length of the lens 22, the pitch of the diffraction grating in the diffractive element 23, and a distance between each of the sections of the optical resonator 2.

According to the optical resonator 2 configured as described above, the beam quality can be improved by spatially combining the beams of light of the plurality of laser emitters 31 to 33 with the beams of light simultaneously resonating. According to the present embodiment, the output coupler 4 has a structure that can adjust the reflectance in the optical resonator 2 as described above. Hereinafter, a configuration of the output coupler 4 is described.

1-1-1. Configuration of output coupler

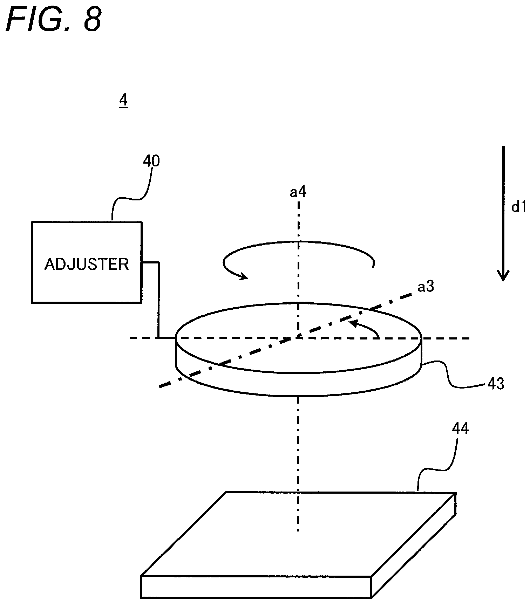

The configuration of the output coupler 4 in the optical resonator 2 of the present embodiment is described with reference to FIGS. 2 and 8. FIG. 8 is a diagram for illustrating a mechanism of the output coupler 4 in the optical resonator 2.

The output coupler 4 of the present embodiment makes it possible to adjust the reflectance inside the output coupler 4 by utilizing the polarization of light. As shown in FIG. 2, the output coupler 4 includes, for example, a half-wave plate 41, an s/p separator 42, a quarter-wave plate 43, and a mirror 44 which are sequentially arranged in the +d1 direction. Furthermore, the output coupler 4 according to the present embodiment includes an adjuster 40 that adjusts a direction of an optical axis a3 (FIG. 8) of the quarter-wave plate 43.

The half-wave plate 41 is arranged on the +d1 side of the diffractive element 23 in the optical resonator 2. The half-wave plate 41 is arranged so as to invert an s-polarized component and a p-polarized component of the incident light. The optical axis of the half-wave plate 41 of the present embodiment is inclined by 45 degrees with respect to an oscillation direction of the electric field of p-polarized light or s-polarized light in a plane perpendicular to a traveling direction of light, and functions as a polarization inverter for inverting the polarized component.

The s/p separator 42 is an example of a polarization beam splitter that separates the s-polarized component and the p-polarized component of the incident light. The s/p separator 42 is constituted of, for example, a polarized beam splitter. For example, the s/p separator 42 reflects s-polarized light and transmits p-polarized light.

The quarter-wave plate 43 causes a phase difference of a quarter wavelength between the polarized components orthogonal to each other in the incident light, with the optical axis a3 as a reference. The optical axis a3 of the quarter-wave plate 43 is, for example, a fast axis or a slow axis.

The mirror 44 is, for example, a total reflection mirror. The mirror 44 is arranged so as to face the quarter-wave plate 43.

As shown in FIG. 8, the output coupler 4 has, for example, an optical axis a4 of the light path along the d1 direction, according to the light path up to the mirror 44. The quarter-wave plate 43 is arranged such that, for example, the optical axis a3 is rotatable on a plane orthogonal to the optical axis a4 of the output coupler 4.

The adjuster 40 includes various rotation mechanisms that cause the quarter-wave plate 43 to rotate around the optical axis a4, for example. The adjuster 40 may include an actuator or the like that drives the rotation mechanisms under the control of the controller 12. The actuator may be provided outside the optical resonator 2, or may be appropriately omitted when the rotation mechanism is used manually.

## 2. Operation

Hereinafter, the operations of the laser processing machine 1 and the optical resonator 2 configured as above are described.

The laser processing machine 1 (FIG. 1) of the present embodiment sets the oscillation conditions of the light source driver 11 from the controller 12 and causes the light source driver 11 to drive the light source 3 of the optical resonator 2. Thereby, in the optical resonator 2, the light is resonated under the set oscillation condition, and the output light L1 can be obtained from the output coupler 4.

At this time, for example, the controller 12 controls the adjuster 40 of the output coupler 4 according to the set oscillation condition, whereby the oscillation efficiency in the optical resonator 2 can be easily optimized. The operation of the optical resonator 2 in the above laser processing machine 1 is described below.

### 2-1. Operation of optical resonator

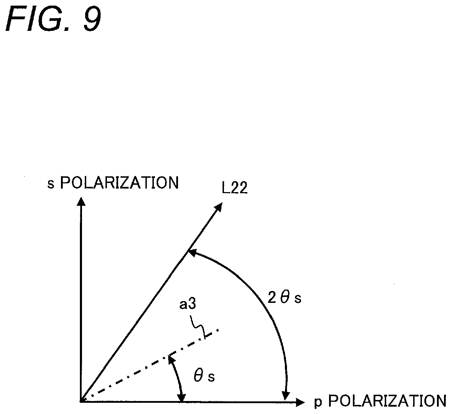

The operation of the optical resonator 2 according to the present embodiment is described with reference to FIGS. 2 and 9.

In the optical resonator 2 of the present embodiment, the light source 3 emits light from each of the plurality of laser emitters 31 to 33. The light from each of the laser emitters 31 to 33 is incident on the lens 22 via the BTU 21 with the fast axis a1 of the beam oriented in the X direction. In the present embodiment, the light from the laser emitters 31 to 33 exiting from the BTU 21 are p-polarized.

The lens 22 guides each beam of light to the vicinity of the diffractive element 23 so as to combine the beams of light from the plurality of laser emitters 31 to 33. The light from the laser emitters 31 to 33 are converted into s-polarized light before being incident on the diffractive element 23 by a half-wave plate (not shown) arranged between the BTU 21 and the diffractive element 23. The diffractive element 23 diffracts the light incident from each of the laser emitters 31 to 33 to emit spatially combined light L10 in the +d1 direction. The combined light L10 has a polarization direction that is also preserved, and is s-polarized.

The s-polarized light L10 is incident on the output coupler 4 from the diffractive element 23. The light L10 incident on the output coupler 4 is converted from s-polarized light to p-polarized light at the half-wave plate 41. Converted light L11 proceeds in the +d1 direction without being particularly separated by the s/p separator 42.

The light L11 travels from the s/p separator 42 in the + d1 direction, and then the light L11 passes through the quarter-wave plate 43. Assuming that the optical axis a3 is the slow axis, the quarter-wave plate 43 delays a phase of the polarized component corresponding to the optical axis a3 in the passing light L11 by a quarter wavelength. Light L12 traveling in the +d1 direction through the quarter-wave plate 43 is reflected by the mirror 44. The reflected light L21 travels in the -d1 direction, passes through the quarter-wave plate 43 again, and is incident on the s/p separator 42.

As described above, light L22 that has passed through the quarter-wave plate 43 twice has a phase difference of a half wavelength with respect to the optical axis a3. Therefore, the light L22 incident on the s/p separator 42 from the quarter-wave plate 43 is linearly polarized light containing the s-polarized component and the p-polarized component at a ratio according to the direction of the optical axis a3 of the quarter-wave plate 43.

The s/p separator 42 reflects the s-polarized component but transmits the p-polarized component in the light L22 from the quarter-wave plate 43, thereby to separate s-polarized light L23 and p-polarized light L24. The s-polarized light L23 that is separated is output from the output coupler 4 as the output light L1 to the outside. The p-polarized light L24 travels in the output coupler 4 in the -d1 direction and is incident on the half-wave plate 41.

The half-wave plate 41 converts the light L24 from the s/p separator 42 from p-polarized light to s-polarized light, and emits s-polarized light L25 from the output coupler 4 in the -d1 direction. Thereby, the output coupler 4 can return the light L25 having the same polarization state as the incident light L10 to the diffractive element 23. The diffracted L25 by the diffractive element 23 is converted into p-polarized light by the half-wave plate (not shown) arranged between the BTU 21 and the diffractive element 23, and returns to the laser emitters 31 to 33 according to the diffraction angle.

As described above, according to the output coupler 4, at a ratio according to the direction of the optical axis a3 of the quarter-wave plate 43, a part of the incident light L10 is output to the outside as the output light L1, and the rest is returned to the diffractive element 23. This allows the light to resonate between the light source 3 and the output coupler 4. The resonance of light occurs in the light path between the mirror 44 of the output coupler 4 and the -Z side end surface of each of the laser emitters 31 to 33 of the light source 3.

The oscillation efficiency of the optical resonator 2 changes according to a ratio of returning the light (or reflectance) from the output coupler 4. The optimum ratio of returning the light differs depending on various oscillation conditions. According to the output coupler 4 of the present embodiment, by changing the direction of the optical axis a3 of the quarter-wave plate 43, the ratio between the output light L1 of the optical resonator 2 and the returned light L25 can be easily adjusted. A method of adjusting the output coupler 4 is described with reference to FIG. 9.

FIG. 9 is a diagram showing a relationship between the optical axis a3 of the quarter-wave plate 43 of the output coupler 4 and the polarization direction. FIG. 9 shows the optical axis a3 and the directions of various polarizations on a principal surface of the quarter-wave plate 43.

As described above, the light L11 that is incident on the quarter-wave plate 43 from the s/p separator 42 is p-polarized light. The light L22 emitted from the quarter-wave plate 43 to the s/p separator 42 has the phase difference of the half wavelength with respect to the optical axis a3. Therefore, as shown in FIG. 9, the polarization direction of the light L22 has an angle $2\theta s$ that is twice an angle $\theta s$ of the optical axis a3 with respect to the p-polarized light.

Therefore, by adjusting the angle $\theta s$ of the optical axis a3 of the quarter-wave plate 43 by the adjuster 40 appropriately, a ratio of mixing the s-polarized light and the p-polarized light in the light L22 can be set to a desired ratio. As a result, the reflectance of the s/p separator 42 can be set, and the ratio of returning the light from the output coupler 4 can be freely adjusted.

### 3. Summary

As described above, the optical resonator 2 according to the present embodiment includes the light source 3 and the output coupler 4. The light source 3 emits light. The output coupler 4 resonates the light emitted from the light source 3 and emits the output light L1. The output coupler 4 includes the mirror 44, the s/p separator 42 as an example of the polarization beam splitter, the quarter-wave plate 43, and the adjuster 40. The mirror 44 is arranged to reflect the light from the light source 3. The s/p separator 42 is arranged on the light path between the light source 3 and the mirror 44, and for example, among the light incident from the mirror 44, emits the p-polarized component (first polarized component) to the light source 3, and emits the s-polarized component (second polarized component) as the output light L1. The quarter-wave plate 43 is arranged between the s/p separator 42 and the mirror 44. The quarter-wave plate 43 has the optical axis a3 that imparts the phase difference of a quarter wavelength to the incident light. The adjuster 40 adjusts the direction of the optical axis a3 of the quarter-wave plate 43.

According to the optical resonator 2 described above, the ratio of mixing the polarized components separated by the s/p separator 42 can be changed by adjusting the direction of the optical axis a3 of the quarter-wave plate 43 by the adjuster 40. This makes it easy to adjust the optical oscillation efficiency of the optical resonator 2 without the need to replace the optical component.

In the present embodiment, the light source 3 includes the plurality of laser emitters 31 to 33, each of which is an example of the light emitter. The optical resonator 2 further includes the diffractive element 23 that diffracts the light of each wavelength so that the beams of light having a plurality of wavelengths are resonated for each of the laser emitters 31 to 33.

According to the optical resonator 2 described above, when a good beam quality is obtained in the wavelength addition type optical resonator 2, the oscillation efficiency can be optimized easily by spatially combining the beams of light of the laser emitters 31 to 33 having the plurality of resonance spectra S1 to S3.

In the present embodiment, the output coupler 4 further includes the half-wave plate 41 arranged between the diffractive element 23 and the s/p separator 42. The half-wave plate 41 inverts the first polarized component and the second polarized component in the incident light. The half-wave plate 41 can emit the p-polarized light L11 to the s/p separator 42 when the light L10 incident on the half-wave plate 41 from the diffractive element 23 is s-polarized light.

In the present embodiment, the optical resonator 2 further includes the BTU 21. The BTU 21 adjusts the beams of light emitted from the light source 3. As a result, the beams of light can be spatially combined in the fast axis a1 of each beam from the light source 3.

The laser processing machine 1 according to the present embodiment includes the optical resonator 2 and the controller 12. The controller 12 controls the light emission of the light source 3 in the optical resonator 2 via the light source driver 11, for example. According to the laser processing machine 1 of the present embodiment, the optical resonator 2 can facilitate the adjustment of the light oscillation efficiency.

(Second embodiment)

A second embodiment is described below with reference to the drawings. In the second embodiment, an optical resonator that can reduce dependency on wavelength in the output coupler is described.

Hereinafter, the optical resonator according to the present embodiment is described while a configuration and an operation similar to those of the first embodiment are appropriately omitted.

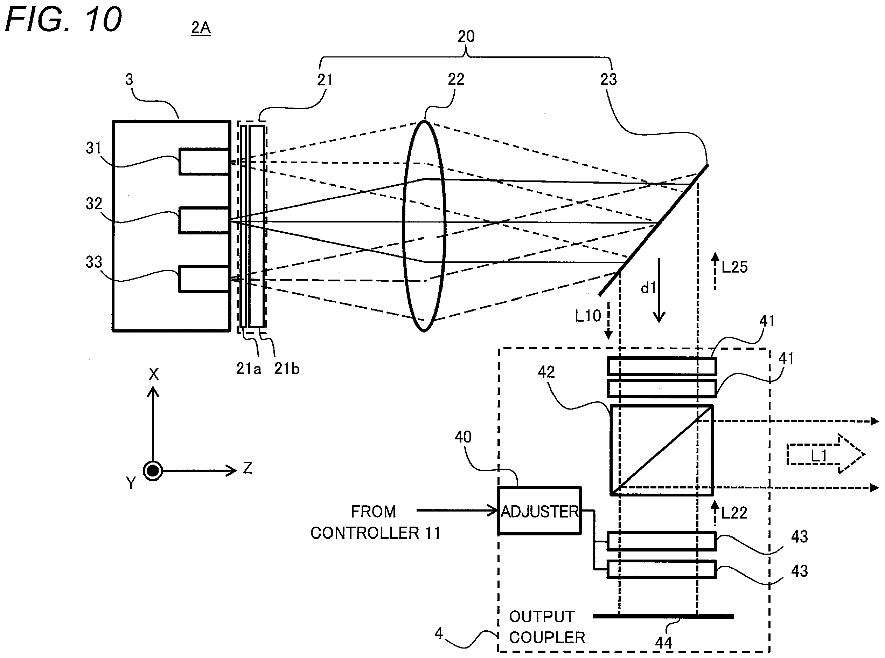

FIG. 10 is a diagram showing the configuration of an optical resonator 2A according to the second embodiment. The optical resonator 2A of the present embodiment includes two pieces of quarter-wave plates 43 and two pieces of half-wave plates 41, in the same configuration as the optical resonator 2 of the first embodiment (FIG. 2).

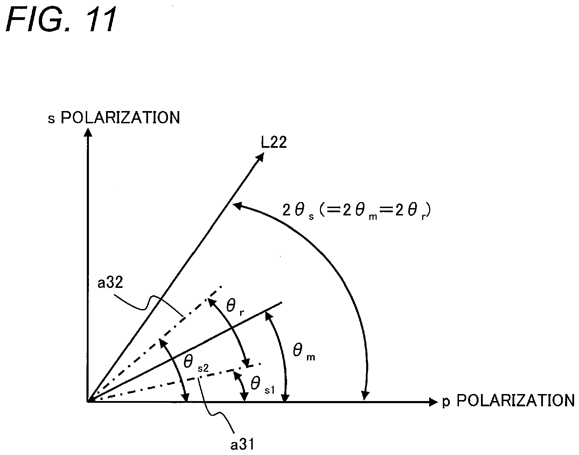

In an output coupler 4 of the present embodiment, the two pieces of quarter-wave plates 43 are arranged between an s/p separator 42 and a mirror 44, similarly to the quarter-wave plate 43 of the first embodiment. An adjuster 40 of the output coupler 4 adjusts each of the quarter-wave plates 43 so as to meet the following relationship between one optical axis (hereinafter referred to as "first optical axis") and the other optical axis (hereinafter referred to as "second optical axis") of the two pieces of quarter-wave plates 43 (see FIG. 11). Note that the first optical axis and the second optical axis are both set to the fast axes or both set to the slow axes.

The two pieces of half-wave plates 41 are arranged between a diffractive element 23 and the s/p separator 42, similarly to the half-wave plate 41 of the first embodiment. Each of the half-wave plates 41 is arranged such that the s-polarized component is converted into the p-polarized component and the p-polarized component is converted into the s-polarized component before and after passing through the two pieces of half-wave plates 41. This can reduce the dependency on wavelength for inverting the s-polarized component and the p-polarized component with each other.

FIG. 11 is a diagram showing the relationship between optical axes a31 and a32 of the two pieces of quarter-wave plates 43 and a polarization direction in the optical resonator 2A of the present embodiment. In FIG. 11, an angle $\theta s1$ of the first optical axis a31 and an angle $\theta s2$ of the second optical axis a32 in the two pieces of quarter-wave plates 43 are shown in the same manner as in FIG. 9.

The optical resonator 2A of the present embodiment reduces a variation in phase difference depending on the wavelength of light by performing optical rotation that provides the phase difference in the light passing through each of the two pieces of quarter-wave plates 43. Specifically, when the polarization direction of light L22 to be incident on the s/p separator 42 is set to an angle $2\theta s$ as in the first embodiment, the adjuster 40 adjusts the angles $\theta s1$ and $\theta s2$ of the first and second optical axes a31 and a32 so as to satisfy the following equations (2), (3), and (4).

$$\theta s = \theta m = \theta r \qquad \ldots (2)$$

$$\theta m = (\theta s1 + \theta s2)/2 \quad \ldots (3)$$

$$\theta r = \theta s2 - \theta s1 \qquad \ldots (4)$$

According to the above equations (2) to (4), the variation in the phase difference that may occur when the light passes one of the two pieces of quarter-wave plates 43 is reduced by passing the other of the two pieces of quarter-wave plates 43. As a result, the dependency on wavelength can be reduced in the case when the polarization direction of the light L22 incident on the s/p separator 42 is adjusted.

As described above, in the optical resonator 2A of the present embodiment, the output coupler 4 includes the two pieces of quarter-wave plates 43. The adjuster 40 adjusts the direction of the optical axis a3 of each of the quarter-wave plates 43. Accordingly, the wavelength-dependent variation in, for example, the wavelength addition type optical resonator 2A can be reduced, and the oscillation efficiency can be adjusted with high accuracy.

In the present embodiment, the output coupler 4 includes two pieces of the half-wave plates 41. According to the two pieces of half-wave plates 41, the wavelength dependence can be reduced at the time of inverting the polarized component in the output coupler 4, according to the same principle as in FIG. 11.

(Other embodiments)

As described above, the first and second embodiments have been described as examples of the technique disclosed in the present application. However, the technique in the present disclosure is not limited to this, and is also applicable to embodiments in which changes, replacements, additions, omissions, and the like are appropriately made. Further, the constituent elements described in each of the above-described embodiments can be combined to form a new embodiment. Therefore, other embodiments are exemplified below.

In the second embodiment, the optical resonator 2A including the two pieces of quarter-wave plates 43 and the two pieces of half-wave plates 41 has been described. An optical resonator according to the present embodiment may include one piece of quarter-wave plate 43 and two pieces of half-wave plates 41, or two pieces of quarter-wave plates 43 and one piece of half-wave plate 41.

In each of the above first and second embodiments, the s/p separator 42 that reflects s-polarized light and transmits p-polarized light have been described as an example of the polarization beam splitter. A polarization beam splitter of the optical resonator according to the present embodiment is not limited to this, and for example, an s/p separator that transmits s-polarized light and reflects p-polarized light may be used. Furthermore, various optical elements may be added or replaced in the optical resonator.

In each of the above embodiments, the optical resonator using the half-wave plate has been described, however, the half-wave plate may be omitted as appropriate.

In each of the above embodiments, an example of the optical system included in the optical resonator 2 has been described, however, an optical resonator 2 of the present embodiment may further include another optical system as appropriate. For example, the optical resonator 2 may include a slow axis collimator (SAC) or the like. The optical resonator 2 may include a plurality of units including a light source 3, a BTU 21, and a lens 22, and a diffractive element 23 may be shared by the respective units.

In each of the above-described embodiments, an example has been described in which the transmission type diffractive element 23 is used in the optical resonator 2, however, the present disclosure is not particularly limited to the transmission type diffractive element. An optical resonator 2 of the present embodiment may be configured by using a reflection type diffractive element.

As described above, the embodiments have been described as examples of the technique in the present disclosure. To that end, the accompanying drawings and detailed description are provided.

Therefore, among the constituent elements described in the accompanying drawings and the detailed description, not only the constituent elements that are essential for solving the problem, but also the constituent elements that are not essential for solving the problem may also be included in order to illustrate the above technique. Therefore, it should not be immediately acknowledged that the above non-essential constituent elements are essential based on the fact that the non-essential constituent elements are described in the accompanying drawings and the detailed description.

Further, because the above-described embodiments are for exemplifying the technique of the present disclosure, various changes, substitutions, additions, omissions, and the like can be made within the scope of the claims or the scope of equivalents thereof.

**Claims**

1. An optical resonator comprising:

   a light source that emits light; and
   an output coupler that resonates the light emitted from the light source to emit output light,
   wherein the output coupler includes:

      a mirror arranged to reflect the light from the light source;
      a polarization beam splitter arranged on a light path between the light source and the mirror, and emitting, out of light incident thereon after emitted from the mirror, a first polarized component to the light source and a second polarized component as the output light;
      at least one quarter-wave plate arranged between the polarization beam splitter and the mirror, and having an optical axis that provides a phase difference by a quarter wavelength in light incident thereon; and
      an adjuster that adjusts a direction of the optical axis of the quarter-wave plate.

2. The optical resonator according to claim 1,
   wherein the light source includes a plurality of light emitters, and
   wherein the optical resonator further comprising a diffractive element that diffracts light of each of a plurality of wavelengths so as to resonate the light of the plurality of wavelengths for each of the light emitters.

3. The optical resonator according to claim 2,
   wherein the output coupler further includes at least one half-wave plate arranged between the diffractive element and the polarization beam splitter, and
   wherein the half-wave plate inverts the first polarized component and the second polarized component in light incident thereon.

4. The optical resonator according to claim 3, wherein the output coupler includes two pieces of the half-wave plates.

5. The optical resonator according to any one of claims 1 to 4, wherein the output coupler includes two pieces of the quarter-wave plates, and wherein the adjuster adjusts the direction of the optical axis of each of the quarter-wave plates.

6. The optical resonator according to any one of claims 1 to 5, further comprising a beam twister unit that adjusts a beam of light emitted at the light source.

7. A laser processing machine comprising:

the optical resonator according to any one of claims 1 to 6, and a controller that controls light emission of the light source in the optical resonator.

*FIG. 1*

1

11 LIGHT SOURCE DRIVER

2

20

31
32
33

3

4

OUTPUT COUPLER

L1

OPTICAL RESONATOR

12 CONTROLLER

*FIG. 2*

EP 3 761 463 A1

# FIG. 3

# FIG. 4

31, 32, 33

a1

21a

21

Y

Z

X

FIG. 5

# FIG. 6

FROM
LASER EMITTER 31

FROM
LASER EMITTER 32

FROM
LASER EMITTER 33

23

$\alpha 1$

$\alpha 2$

$\alpha 3$

$\beta$

$\beta$

$\beta$

$d1$

TO OUTPUT
COUPLER 4

## FIG. 7

## FIG. 8

4

40

ADJUSTER

a4

d1

a3

43

44

# FIG. 9

s POLARIZATION     L22

a3

$2\theta s$

$\theta s$

p POLARIZATION

FIG. 10

# FIG. 11

s POLARIZATION

L22

$2\theta_s\ (=2\theta_m=2\theta_r)$

a32

$\theta_r$

$\theta_m$

$\theta_{s2}$

$\theta_{s1}$

a31

p POLARIZATION

## INTERNATIONAL SEARCH REPORT

| | International application No. |
|---|---|
| | PCT/JP2019/001030 |

A. CLASSIFICATION OF SUBJECT MATTER

Int.Cl.  H01S5/022(2006.01)i,  B23K26/00(2014.01)i,  G02B26/06(2006.01)i,
         H01S3/00(2006.01)i, H01S3/10(2006.01)i

According to International Patent Classification (IPC) or to both national classification and IPC

B. FIELDS SEARCHED

Minimum documentation searched (classification system followed by classification symbols)

Int.Cl.  H01S5/00-5/50, B23K26/00-26/70, G02B26/00-26/08, H01S3/00-4/00

| Documentation searched other than minimum documentation to the extent that such documents are included in the fields searched | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 11-097782 A (HAMAMATSU PHOTONICS K.K.) 09 April 1999, paragraphs [0012]-[0014], fig. 1 (Family: none) | 1<br>2-7 |
| Y | JP 2011-205061 A (KOMATSU LTD.) 13 October 2011, paragraphs [0018]-[0023], fig. 3 & US 2012/0012762 A1, paragraphs [0068]-[0071], fig. 3 & WO 2011/108761 A1 & EP 2542936 A1 | 2-7 |

☒ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 29 March 2019 (29.03.2019) | 09 April 2019 (09.04.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2019/001030 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2015-210838 A (SUMITOMO ELECTRIC INDUSTRIES, LTD.) 24 November 2015, paragraphs [0017]-[0018], fig. 1 & US 2017/0219755 A1, paragraphs [0025]-[0029], fig. 1 & WO 2015/166882 A1 & EP 3139384 A1 | 4-7 |
| Y | WO 2016/063436 A1 (PANASONIC IP MANAGEMENT CO., LTD.) 28 April 2016, paragraphs [0021]-[0023], fig. 9-15 & US 2017/0288365 A1, paragraphs [0048]-[0051], fig. 9-15 & EP 3211734 A1 & CN 106797102 A | 6-7 |
| Y | JP 2009-262223 A (SUNX LTD.) 12 November 2009, paragraphs [0024]-[0032], fig. 1 (Family: none) | 7 |
| Y | JP 2016-032831 A (KEYENCE CORP.) 10 March 2016, paragraphs [0035]-[0044], fig. 1-2 & US 2016/0036194 A1, paragraphs [0048]-[0058], fig. 1-2 & DE 102015214511 A1 & CN 105312783 A | 7 |
| A | JP 07-193303 A (TOSHIBA CORP.) 28 July 1995, entire text, all drawings (Family: none) | 1-7 |
| A | JP 2014-056926 A (SANYO ENGINEERING & CONSTRUCTION INC.) 27 March 2014, entire text, all drawings (Family: none) | 1-7 |
| A | US 2007/0268571 A1 (NEWPORT CORPORATION) 22 November 2007, entire text, all drawings & WO 2007/137005 A2 | 1-7 |

Form PCT/ISA/210 (continuation of second sheet) (January 2015)

**EP 3 761 463 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002344051 A